# EUROPEAN PATENT APPLICATION

(11) **EP 4 769 408 A1**
(43) Date of publication of application: **01.07.2026**
(21) Application number: 24856161.5
(22) Date of filing: 08.07.2024
(51) Int. Cl.: G11C 11/22

(54) **SEMICONDUCTOR MEMORY DEVICE**

(30) Priority: 24.08.2023 JP 2023136164
(71) Applicant: Sony Semiconductor Solutions Corporation, Atsugi-shi, Kanagawa 243-0014 (JP)
(72) Inventor: YONAI, Tsubasa, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/024535
(87) International publication number: WO 2025/041466

(57) **Abstract**

A semiconductor storage apparatus according to an embodiment of the present technology includes a control section. The control section that controls write intensity of writing to a user area included in a memory area, on the basis of a number of times of access to the user area. Thereby, the write intensity is increased when the value of a counter linked with the number of times of access to the user area has exceeded a predetermined number of times, and this makes it possible to achieve extended product lifetime of the semiconductor storage apparatus using ferroelectric memory cells. In addition, the semiconductor storage apparatus is robust against variations in memory initial characteristics and deterioration, and the trade-off between the endurance and the retention after control processes can be eliminated. In addition, recovery enables the maintenance of the read margin, and the endurance and the retention can be enhanced.

## Description

### Technical Field

The present technology relates to a semiconductor storage apparatus using ferroelectric elements.

### Background Art

Conventionally, in a semiconductor storage apparatus using ferroelectric elements, ferroelectric memory cells including ferroelectric capacitors store therein data of 0 or 1 on the basis of the polarization states of the ferroelectric elements. Here, in the semiconductor storage apparatus using ferroelectric elements, it is desirable to achieve better rewrite endurance (endurance) and data retention characteristics (retention). However, it is known that a polarization fatigue phenomenon called fatigue occurs as the number of times of rewriting increases, and an imprint phenomenon called imprint occurs in a case where the same data is retained for a long time.

When fatigue occurs, the remanent polarization amount in the hysteresis characteristics of ferroelectric elements decreases, resulting in an undesirable decrease in the read margin of 0 and 1. In addition, when imprint occurs, the hysteresis characteristics shift, resulting in an undesirable decrease in the read margin of 0 and 1. That is, the degradation of endurance due to fatigue and the degradation of retention due to imprint give rise to the possibility of malfunction in a semiconductor storage apparatus using ferroelectric elements or shortened product lifetime, undesirably.

Patent Literature 1 describes a semiconductor storage apparatus having a fatigue monitor and an imprint monitor that use ferroelectric memory cells. In the semiconductor storage apparatus, each degree of reliability deterioration in memory operation is sensed, and the write intensity is lowered as the deterioration due to fatigue progresses, thereby extending the lifetime. In addition, as the deterioration due to imprint progresses, the write intensity is increased to aim for high memory reliability in preparation for data retention. (Paragraphs [0015] to [0037], Fig. 1, and the like in the specification of Patent Literature 1).

### Citation List

### Patent Literature

Patent Literature 1: JP-2022-150998-A

### Disclosure of Invention

### Technical Problem

There is a demand for such semiconductor storage apparatuses using ferroelectric elements that are capable of achieving extended product lifetime.

In view of the circumstances described above, an object of the present technology is to provide a semiconductor storage apparatus that is capable of achieving extended product lifetime.

### Solution to Problem

In order to achieve the object, a semiconductor storage apparatus according to an embodiment of the present technology includes a control section.

The control section controls write intensity of writing to a user area included in a memory area, on the basis of a number of times of access to the user area.

The semiconductor storage apparatus includes the control section that controls write intensity of writing to a user area included in a memory area, on the basis of a number of times of access to the user area. This makes it possible to achieve extended product lifetime.

The semiconductor storage apparatus may further include a counter area that is provided independently of the memory area, the counter area storing therein the number of times of access. In this case, the control section may control the write intensity in a case where the number of times of access stored in the counter area has exceeded a predetermined number of times.

The control section may increase the write intensity by increasing a write voltage.

The control section may increase the write voltage stepwise.

The write intensity may include a normal mode in which the write voltage is in a normal state, and an increased mode in which the write voltage is in an increased state compared to the normal state. In this case, the control section may control the write intensity to the increased mode in a case where the write intensity is in the normal mode, and may control the write intensity to the normal mode in a case where the write intensity is in the increased mode.

The semiconductor storage apparatus may further include a flag area that is provided independently of the memory area, the flag area storing therein a setting of the user area. In this case, the setting of the user area may include the normal mode and the increased mode. The control section may control the write intensity to the increased mode in a case where the setting of the user area stored in the flag area indicates the normal mode, and may control the write intensity to the normal mode in a case where the setting of the user area stored in the flag area indicates the increased mode.

The control section may increase the write intensity by extending a write pulse width.

The control section may extend the write pulse width stepwise.

The write intensity may include a normal mode in which the write pulse width is in a normal state, and an increased mode in which the write pulse width is in an extended state compared to the normal state. In this case, the control section may control the write intensity to the increased mode in a case where the write intensity is in the normal mode, and may control the write intensity to the normal mode in a case where the write intensity is in the increased mode.

The semiconductor storage apparatus may further include a flag area that is provided independently of the memory area, the flag area storing therein a setting of the user area. In this case, the setting of the user area may include the normal mode and the increased mode. The control section may control the write intensity to the increased mode in a case where the setting of the user area stored in the flag area indicates the normal mode, and may control the write intensity to the normal mode in a case where the setting of the user area stored in the flag area indicates the increased mode.

The semiconductor storage apparatus may further include a random number generating section that probabilistically outputs a random number indicating whether to increase the write intensity. In this case, the control section may control the write intensity on the basis of the random number.

The semiconductor storage apparatus may further include a flag area that is provided independently of the memory area, the flag area storing therein a setting of the user area. In this case, the setting of the user area may include a volatile mode in which the user area functions as a volatile memory, and a non-volatile mode in which the user area functions as a non-volatile memory.

The semiconductor storage apparatus may further include a counter area that is provided independently of the memory area, the counter area storing therein the number of times of access. In this case, the control section may increase the write intensity in a case where the setting of the user area stored in the flag area indicates the volatile mode and in a case where the number of times of access stored in the counter area has exceeded a predetermined number of times.

In a case where the control section has increased the write intensity, the counter area may reset the stored number of times of access, and may store therein a number of times of rewriting of rewriting to the user area in a state where the write intensity has been increased. In this case, the control section may restore the write intensity in a case where the number of times of rewriting performed in the state where the write intensity has been increased has reached a specified number of times.

The semiconductor storage apparatus may further include an intensity control section that controls a read intensity of reading to the user area.

The semiconductor storage apparatus may further include a flag area that is provided independently of the memory area, the flag area storing therein a setting of the user area. In this case, the setting of the user area may include a volatile mode in which the user area functions as a volatile memory, and a non-volatile mode in which the user area functions as a non-volatile memory. The intensity control section may increase the read intensity in a case where the user area is in the non-volatile mode.

The semiconductor storage apparatus may further include a counter area that is provided independently of the memory area, the counter area storing therein the number of times of access. In this case, the control section may increase the write intensity in a case where the setting of the user area stored in the flag area indicates the volatile mode and in a case where the number of times of access stored in the counter area has exceeded a predetermined number of times.

The setting of the user area may include a first mode in which the read intensity and the write intensity are increased, a second mode in which either one of the read intensity or the write intensity is increased, and a third mode in which the read intensity and the write intensity are maintained in normal states.

The memory area may be a ferroelectric memory cell.

The ferroelectric memory cell may contain hafnium oxide and zirconium oxide.

### Brief Description of Drawings

[Fig. 1] Fig. 1 is a block diagram illustrating a configuration example of a semiconductor storage apparatus.
[Fig. 2] Fig. 2 illustrates an example of a ferroelectric memory cell array that a memory area section has.
[Fig. 3] Fig. 3 illustrates an example in which the polarization amount is recovered by increasing the write voltage.
[Fig. 4] Fig. 4 illustrates an example of a voltage adjustment circuit.
[Fig. 5] Fig. 5 is a flowchart illustrating a control method performed by a control section.
[Fig. 6] Fig. 6 illustrates an example in a case where the write voltage is increased.
[Fig. 7] Fig. 7 is a block diagram illustrating a configuration example of a semiconductor storage apparatus.
[Fig. 8] Fig. 8 is a flowchart illustrating a control method performed by the control section.
[Fig. 9] Fig. 9 illustrates an example in a case where the write pulse width is extended.
[Fig. 10] Fig. 10 is a block diagram illustrating a configuration example of a semiconductor storage apparatus.
[Fig. 11] Fig. 11 is a flowchart illustrating a control method performed by the control section.
[Fig. 12] Fig. 12 is a flowchart illustrating a control method performed by the control section.
[Fig. 13] Fig. 13 is a flowchart illustrating a control method performed by the control section.
[Fig. 14] Fig. 14 illustrates simulation results in which read failures are mitigated by increasing the read voltage.

### Mode(s) for Carrying Out the Invention

Hereinbelow, embodiments according to the present technology are explained with reference to the drawings.

### <First Embodiment>

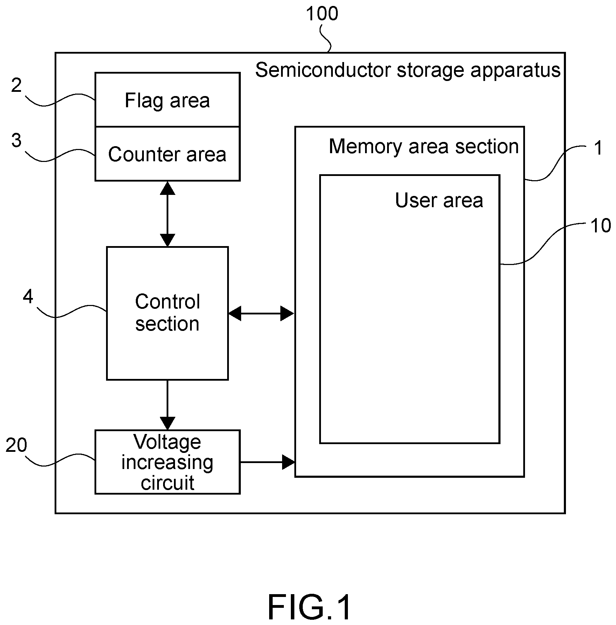

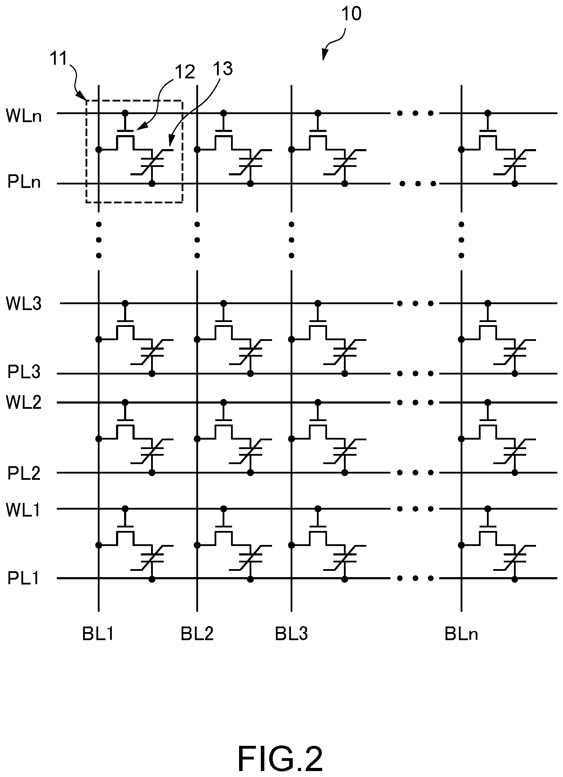

[Configuration of Semiconductor Storage Apparatus] Fig. 1 is a block diagram illustrating a configuration example of a semiconductor storage apparatus 100 according to a first embodiment of the present technology. Fig. 2 illustrates an example of a ferroelectric memory cell array that a memory area section 1 has.

As illustrated in Fig. 1, the semiconductor storage apparatus 100 has the memory area section 1, a control section 4, a voltage increasing circuit 20, a flag area 2, and a counter area 3.

The memory area section 1 has a ferroelectric memory cell array. The ferroelectric memory cell array functions as a user area 10 that is externally accessible for a user of the semiconductor storage apparatus 100. Note that access includes reading to and writing to the user area 10.

As illustrated in Fig. 2, each ferroelectric memory cell included in the ferroelectric memory cell array is connected to a word line (WLn), a bit line (BLn), and a plate line (PLn).

Each ferroelectric memory cell has an n-channel type MOSFET (access transistor) and a ferroelectric capacitor. For example, a ferroelectric memory cell 11 has an n-channel type MOSFET 12 and a ferroelectric capacitor 13.

The gate of the n-channel type MOSFET 12 is connected to WLn. One of the drain or source of the n-channel type MOSFET 12 is connected to BLn. The other of the drain or source of the n-channel type MOSFET 12 is connected to one end of the ferroelectric capacitor 13. The other end of the ferroelectric capacitor 13 is connected to PLn. Other ferroelectric memory cells also have similar circuitry configuration.

Note that the memory area section 1 may include components such as decoders and drivers that select word lines, bit lines, or plate lines and apply predetermined voltages depending on input addresses, commands, write data, or the like and may include sense amplifiers.

The control section 4 controls the write intensity of writing to the user area 10. In the present embodiment, the control section 4 controls the write intensity of writing to the user area 10 on the basis of the flag area 2 and the counter area 3 described later. In addition, in the present embodiment, the control section 4 increases the write intensity by outputting, to the voltage increasing circuit 20 described later, a control signal instructing the voltage increasing circuit 20 to increase the write voltage.

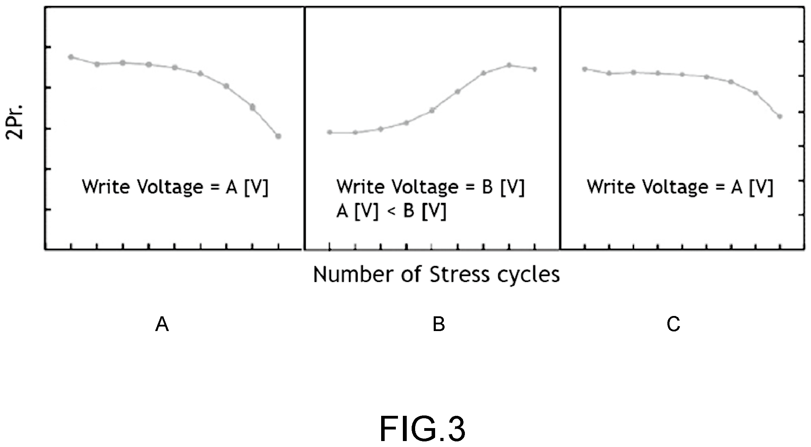

Here, recovery resulting from an increase in the write intensity is explained using Fig. 3. There is a phenomenon called fatigue that occurs in ferroelectric memory cells, in which the signal level used for memory operation, which is 2Pr. (remanent polarization), decreases with repeated rewriting. On the other hand, there is a phenomenon in which 2Pr. recovers by repeating rewriting with a write intensity greater than the initial condition. This is called recovery.

Fig. 3 illustrates an example in which the polarization amount is recovered by increasing the write voltage. A in Fig. 3 illustrates an example in which 2Pr. decreases due to fatigue. B in Fig. 3 illustrates an example in which 2Pr recovers due to recovery. C in Fig. 3 illustrates an example in which 2Pr. decreases due to fatigue again.

In addition, in Fig. 3, the horizontal axis represents the number of times of writing, and the vertical axis represents the remanent polarization (2Pr.). In addition, the write voltage in A in Fig. 3 is A [V], the write voltage in B in Fig. 3 is B [V] which is greater than A [V], and the write voltage in C in Fig. 3 is A [V].

As illustrated in A in Fig. 3, it can be known that fatigue occur as the number of times of writing increases, and 2Pr. decreases in a case where the write voltage is A [V].

In B in Fig. 3, the write voltage is increased, the write voltage is changed to B [V], and writing to the memory area is performed. In this case, 2Pr. increases as the number of times of writing increases. That is, recovery occurs.

In addition, in C in Fig. 3, recovered 2Pr. decreases again as the number of times of writing increases. That is, by inducing recovery every time the number of times of access exceeds a predetermined number of times, it is possible to reduce the possibility of the occurrence of malfunction in the semiconductor storage apparatus caused by a decrease in the remanent polarization amount, that is, a decrease in the read margin of 0 and 1.

By using recovery in this manner, it is possible to enhance the rewrite endurance (endurance) and the data retention characteristics (retention).

Note that this recovery phenomenon does not occur in PZT (lead zirconate titanate) conventionally used in ferroelectric memory cells. In the present embodiment, a mixed crystal containing hafnium oxide (HfO2) and zirconium oxide (ZrO2) is used in the ferroelectric memory cells. Note that the material used in the ferroelectric memory cells is not limited, as long as the material allows the recovery phenomenon to occur.

The voltage increasing circuit 20 increases the write voltage. In the present embodiment, the write intensity includes a normal mode in which the write voltage is in a normal state, and an increased mode in which the write voltage is in an increased state compared to the normal state. That is, the voltage increasing circuit 20 performs control to switch between the write voltage corresponding to the normal mode and the write voltage corresponding to the increased mode on the basis of a control signal output from the control section 4.

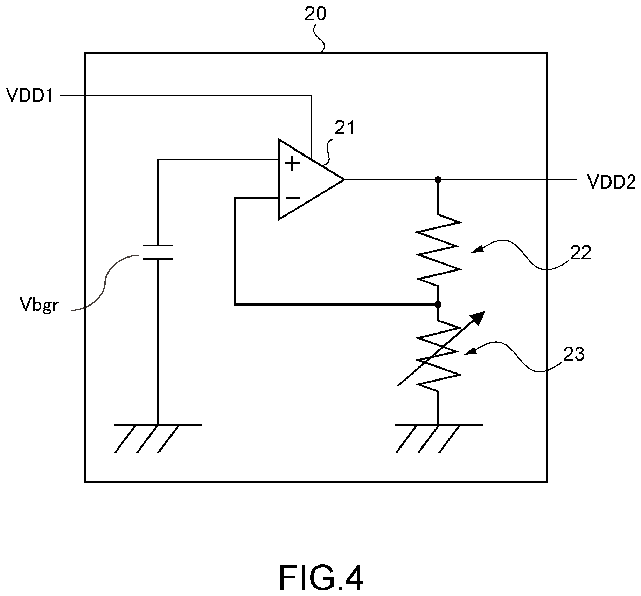

In addition, in the present embodiment, the voltage increasing circuit 20 has a voltage adjustment circuit. Fig. 4 illustrates an example of the voltage adjustment circuit.

As illustrated in Fig. 4, the voltage increasing circuit 20 has a comparator 21, a resistance element 22 having one end connected to the output terminal of the comparator 21, and a variable resistance element 23 having one end connected to the other end of the resistance element 22 and having the other end that is grounded. In Fig. 4, the power supply terminal of the comparator 21 is supplied with a power supply voltage VDD1, and the + input terminal of the comparator 21 has been set to a reference potential Vbgr. In addition, the - input terminal of the comparator 21 is connected to a node connecting the resistance element 22 and the variable resistance element 23.

In such a voltage increasing circuit 20, the resistance value of the variable resistance element 23 is adjusted on the basis of a control signal supplied from the control section 4, thereby adjusting the magnitude of a power supply voltage VDD2, which is an output signal of the comparator 21.

The flag area 2 stores therein settings of the user area 10. For example, the settings of the user area 10 include the state (normal mode and increased mode) of the write intensity of writing to the user area 10, a volatile mode in which the user area 10 functions as a volatile memory, a non-volatile mode in which the user area 10 functions as a non-volatile memory, and the like. For example, the flag area 2 is set to 0 or 1. The flag area 2 is set to 0 in a case where the write intensity is in the normal mode and is set to 1 in a case where the write intensity is in the increased mode. In the present embodiment, the flag area 2 is provided independently of the memory area.

The counter area 3 stores therein the number of times of access to the user area 10. In the present embodiment, the counter area 3 is provided independently of the memory area. For example, the counter area 3 increments the counter every time access is made to the user area 10.

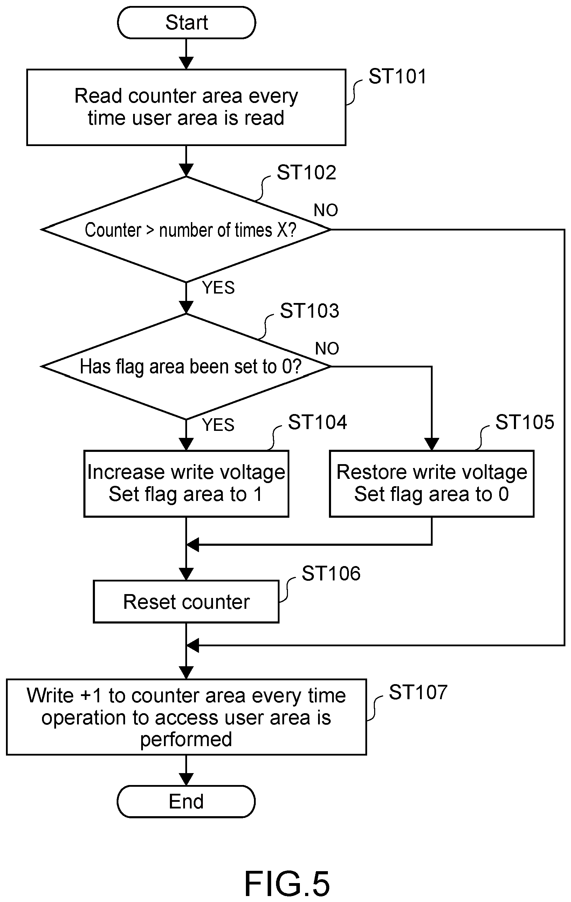

Fig. 5 is a flowchart illustrating a control method performed by the control section 4.

As illustrated in Fig. 5, every time a read operation on the user area 10 is performed, the counter area 3 is read out (Step 101). That is, the number of times indicated by the counter stored in the counter area 3 is read out.

It is determined whether the read number of times indicated by the counter has exceeded a predetermined number of times X (Step 102). In a case where the number of times indicated by the counter has not exceeded the predetermined number of times X (NO at Step 102), +1 is written to the counter area 3 every time access to the user area 10 is made, and the stored number of times indicated by the counter is incremented (Step 107).

In a case where the number of times indicated by the counter has exceeded the predetermined number of times X as the number of times indicated by the counter is incremented at Step 107 (YES at Step 102), a determination regarding the flag area 2 is made (Step 103).

In the present embodiment, the flag area 2 has been set to 0 or 1. In a case where the flag area 2 has been set to 0 (YES at Step 103), the voltage increasing circuit 20 increases the write voltage, and the flag area 2 is set to 1 (Step 104). Typically, in a case where the number of times indicated by the counter has exceeded the predetermined number of times X, fatigue has occurred, and 2Pr. has decreased as illustrated in Fig. 3, which means recovery is necessary. Accordingly, at the initial phase when an operation to access the user area 10 starts (e.g. at the time of initial activation), the flag area 2 is set to 0.

In addition, the number of times indicated by the counter stored in the counter area 3 is reset (Step 105), and the number of times indicated by the counter stored in the counter area 3 is incremented every time access to the user area 10 is made (Step 107).

In addition, in a case where the counter area 3 is read out at Step 101, and the number of times indicated by the counter has not exceeded the predetermined number of times X through the operations described above (NO at Step 102), the number of times indicated by the counter stored in the counter area 3 is incremented every time access to the user area 10 is made (Step 107). That is, until the number of times indicated by the counter exceeds the predetermined number of times X, the recovery phenomenon occurs, and 2Pr. recovers.

In a case where the number of times indicated by the counter has exceeded the predetermined number of times X again (YES at Step 102), a determination regarding the flag area 2 is made (Step 103). Since the flag area 2 has been set to 1 at Step 104 (NO at Step 103) as described above, the voltage increasing circuit 20 restores the write voltage, and the flag area 2 is set to 0 (Step 105).

That is, when the number of times indicated by the counter exceeds the predetermined number of times X for the first time, the write intensity is in the normal mode (the flag area 2 has been set to 0). Accordingly the write intensity transitions to the increased mode, and the flag area 2 is set to 1. Thereafter, every time the number of times indicated by the counter exceeds the predetermined number of times X, the write intensity alternately transitions from the increased mode to the normal mode and from the normal mode to the increased mode.

Note that the predetermined number of times X may be set as desired. For example, the predetermined number of times X may be a number of times of writing at which fatigue is assumed to occur on the basis of simulation results like those illustrated in Fig. 3. In addition, for example, the predetermined number of times X may be changed on the basis of the numbers of times at which the recovery phenomenon has occurred as the first increased mode, the second increased mode, the third increased mode, and the like.

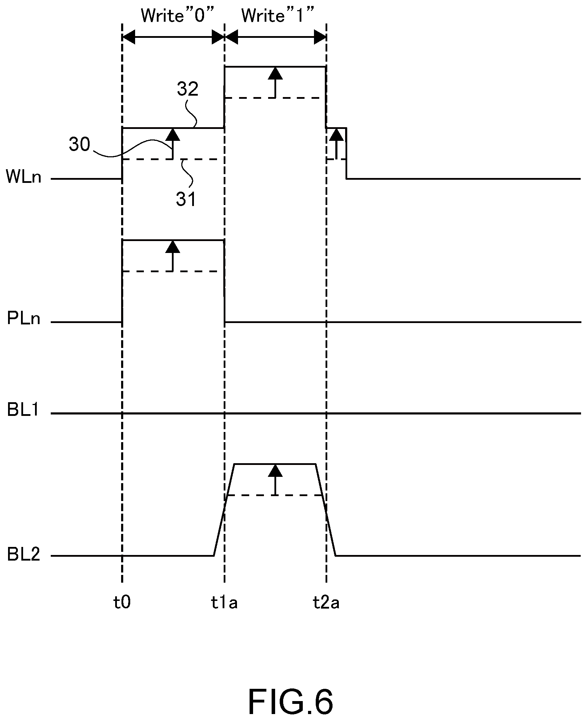

Here, an example in which the write voltage is increased is illustrated using Fig. 6. Fig. 6 illustrates the example in a case where the write voltage is increased.

As illustrated in Fig. 6, at timing t0, a predetermined voltage is applied to WLn and PLn. In a case where BL1 and BL2 remain at 0 V, 0 is written to the ferroelectric memory cell.

When the voltage of PLn falls to 0 V, a higher voltage is applied to WLn, and a voltage for writing 1 is applied to BL2 at timing t1a, 1 is written to the ferroelectric memory cell.

When the voltages of WLn and BL2 fall at timing t2a, the writing of 1 ends. When the power supply voltage VDD2 supplied to the memory area section 1 rises (e.g. +0.1 V), the voltages of WLn, PLn, and BL2 during writing also rise, resulting in a rise in the write voltage.

In addition, in the present embodiment, the control section 4 increases the write voltage stepwise. For example, as illustrated in Fig. 6, the voltage applied while 0 is written (between the timing t0 and the timing t1a) may increase by an amount indicated by an arrow 30 (between a dotted line 31 and a solid line 32). In addition, for example, the voltage applied to WLn may be different between the period during which 0 is written and the period during which 1 is written (between the timing t1a and the timing t2a). Alternatively, the voltage applied during the period between the timing t0 and the timing t1a may increase linearly.

As described above, the semiconductor storage apparatus 100 according to the first embodiment includes a high-voltage driver including the flag area 2, the counter area 3, and the voltage increasing circuit 20 that are independent of the ferroelectric memory cell array (user area 10), and the write intensity is increased when the value of the counter linked with the number of times of access to the user area 10 has exceeded the predetermined number of times. Thereby, it becomes possible to achieve extended product lifetime of the semiconductor storage apparatus using the ferroelectric memory cells.

Since it has conventionally been necessary to prepare ferroelectric memory cells for monitoring fatigue and imprint according to Patent Literature 1, for example, the user area similarly having ferroelectric memory cells is restricted undesirably. In addition, opposing intensity adjustments to lower the rewrite intensity in the case of fatigue deterioration and increase the write intensity in the case of imprint deterioration have been made, but this conventional method undesirably results in a trade-off between two types of reliability, whereby enhancing the endurance leads to deterioration in retention.

In the present technology, by including the flag area 2 and the counter area 3 independent of the ferroelectric memory cell array, the user area 10 is not restricted. In addition, the present technology is robust against variations in memory initial characteristics and deterioration, and the trade-off between the endurance and the retention after control processes can be eliminated. In addition, recovery enables the maintenance of the read margin, and the endurance and the retention can be enhanced.

### <Second Embodiment>

A semiconductor storage apparatus 200 according to a second embodiment of the present technology is explained. In the following explanation, explanation of portions that have configuration and provide effects similar to those of the corresponding portions in the semiconductor storage apparatus 100 explained with reference to the embodiment described above is omitted or simplified.

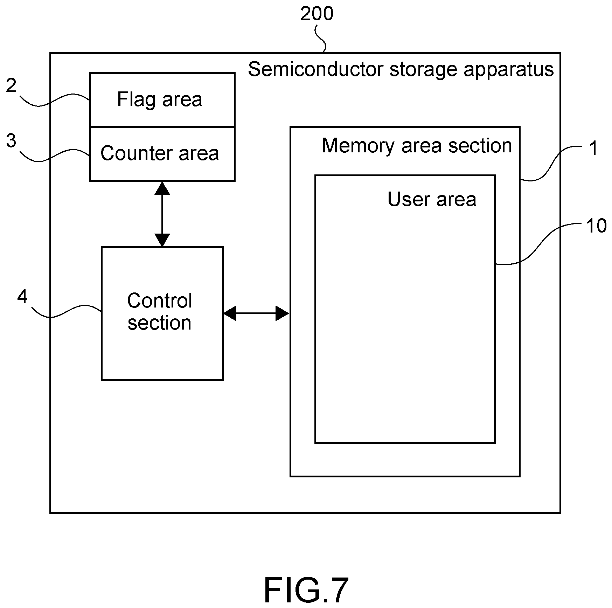

Fig. 7 is a block diagram illustrating a configuration example of the semiconductor storage apparatus 200 according to the second embodiment.

The second embodiment is different from the first embodiment in that the semiconductor storage apparatus 200 does not have the voltage increasing circuit 20 as illustrated in Fig. 7. In addition, the control section 4 increases the write intensity by extending the write pulse width instead of increasing the write voltage.

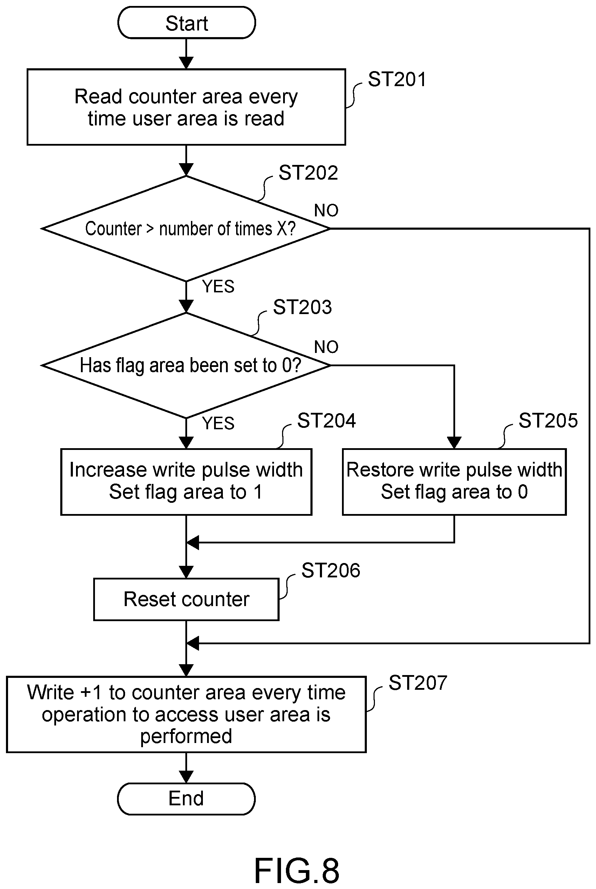

Fig. 8 is a flowchart illustrating a control method performed by the control section 4.

As illustrated in Fig. 8, every time a read operation on the user area 10 is performed, the counter area 3 is read out (Step 201). That is, the number of times indicated by the counter stored in the counter area 3 is read out.

It is determined whether the read number of times indicated by the counter has exceeded the predetermined number of times X (Step 202). In a case where the number of times indicated by the counter has not exceeded the predetermined number of times X (NO at Step 202), the number of times indicated by the counter stored in the counter area 3 is incremented every time access to the user area 10 is made (Step 207) .

In a case where the number of times indicated by the counter has exceeded the predetermined number of times X as the number of times indicated by the counter is incremented at Step 207 (YES at Step 202), a determination regarding the flag area 2 is made (Step 203).

In the second embodiment, the control section 4 controls the write intensity between a normal mode in which the write pulse width is in a normal state and an increased mode in which the write pulse width is in an extended state compared to the normal state. In Fig. 8, in a case where the flag area 2 has been set to 0 (YES at Step 203), the control section 4 extends the write pulse width, and the flag area 2 is set to 1 (Step 204). That is, the write intensity transitions to the increased mode, and the recovery phenomenon occurs.

In addition, the number of times indicated by the counter stored in the counter area 3 is reset (Step 205), and the number of times indicated by the counter stored in the counter area 3 is incremented every time access to the user area 10 is made (Step 207).

In addition, in a case where the counter area 3 is read out at Step 201, and the number of times indicated by the counter has not exceeded the predetermined number of times X through the operations described above (NO at Step 202), +1 is written to the counter area 3 every time access to the user area 10 is made, and the stored number of times indicated by the counter is incremented (Step 207). That is, until the number of times indicated by the counter exceeds the predetermined number of times X, the recovery phenomenon occurs, and 2Pr. recovers.

In a case where the number of times indicated by the counter has exceeded the predetermined number of times X again (YES at Step 202), a determination regarding the flag area 2 is made (Step 203). Since the flag area 2 has been set to 1 at Step 204 (NO at Step 203) as described above, the control section 4 restores the write pulse width, and the flag area 2 is set to 0 (Step 205).

That is, when the number of times indicated by the counter exceeds the predetermined number of times X for the first time, the write intensity is in the normal mode (the flag area 2 has been set to 0), and fatigue has occurred. Accordingly the write intensity transitions to the increased mode, and the flag area 2 is set to 1. Thereafter, every time the number of times indicated by the counter exceeds the predetermined number of times X, the write intensity alternately transitions from the increased mode to the normal mode and from the normal mode to the increased mode.

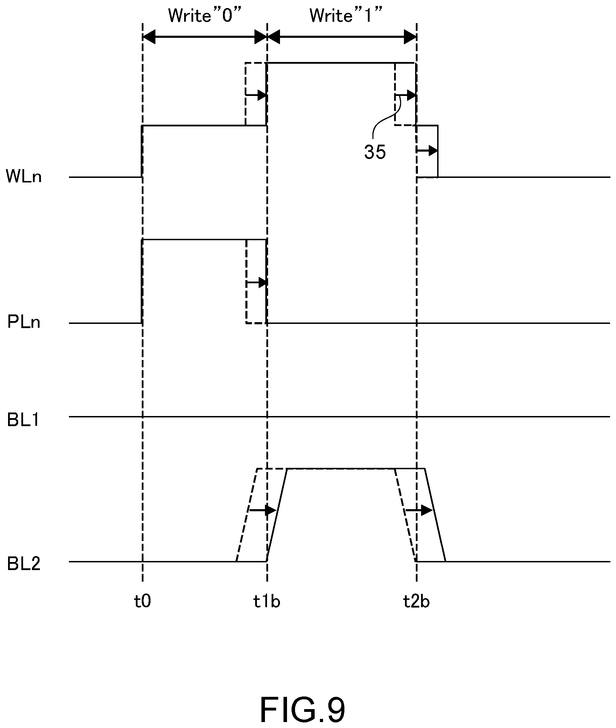

Fig. 9 illustrates an example in a case where the write pulse width is extended.

As illustrated in Fig. 9, at timing t0, a predetermined voltage is applied to WLn and PLn. In a case where BL1 and BL2 remain at 0 V, 0 is written to the ferroelectric memory cell.

At timing t1b, the voltage of PLn falls to 0 V, and a higher voltage is applied to WLn. In addition, when a voltage for writing 1 is applied to BL2, 1 is written to the ferroelectric memory cell.

When the voltages of WLn and BL2 fall at timing t2b, the writing of 1 ends. By extending the write time (the period from the timing t0 to the timing tlb and the period from the timing tlb to the timing t2b) as illustrated in Fig. 9, for example, the write pulse width is extended by +50 ns, and the write intensity is increased.

In addition, in the second embodiment, the control section 4 extends the write pulse width stepwise. For example, the write pulse width may be extended by an amount corresponding to an arrow 35 when the time of the timing tlb and the timing t2b is extended during the period from the timing t0 to the timing tlb and the period from the timing tlb to the timing t2b. In addition, for example, the length of the write pulse width may be extended by different lengths during the period from the timing t0 to the timing tlb and the period from the timing tlb to the timing t2b.

As described above, unlike a conventional semiconductor storage apparatus on which a fatigue monitor that senses fatigue deterioration and an imprint monitor that senses imprint deterioration are mounted, in the semiconductor storage apparatus 200 according to the second embodiment, the write intensity is controlled on the basis of the flag area 2 and the counter area 3 that are provided independently of the user area 10, and accordingly the user area 10 is not restricted. This makes it possible to aim to increase storage capacity. In addition, since it is not necessary to mount a circuit that functions as a voltage adjustment circuit, this leads to a reduction in chip size. Furthermore, the rewrite endurance can be enhanced, and deterioration of the data retention characteristics can be reduced.

### <Third Embodiment>

A semiconductor storage apparatus 300 according to a third embodiment of the present technology is explained.

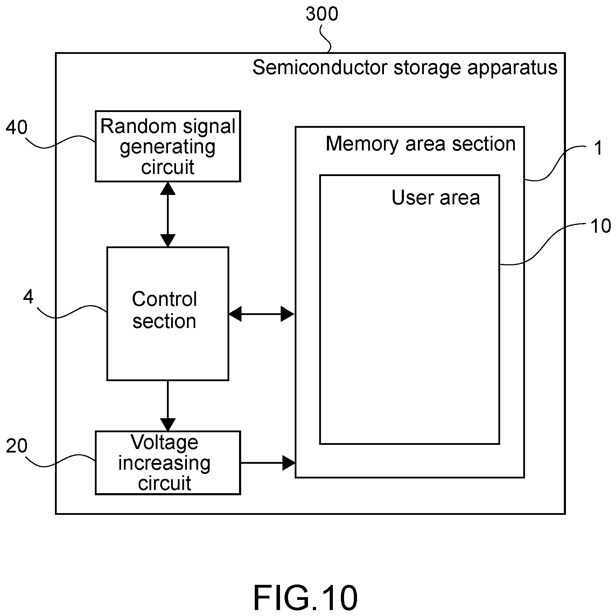

Fig. 10 is a block diagram illustrating a configuration example of the semiconductor storage apparatus 300 according to the third embodiment.

The third embodiment is different from the first embodiment in that the semiconductor storage apparatus 300 does not have the flag area 2 and the counter area 3 as illustrated in Fig. 10. In addition, in addition to the memory area section 1, the control section 4, and the voltage increasing circuit 20, the semiconductor storage apparatus 300 has a random signal generating circuit 40.

The random signal generating circuit 40 generates a random pulse. For example, the random signal generating circuit 40 outputs a pulse of N = 0 or a pulse of N = 1 to the control section 4. Note that the probability of generation of a 0 or 1 pulse output from the random signal generating circuit may be random or biased.

Note that the random signal generating circuit 40 is equivalent to the random number generating section that probabilistically outputs a random number indicating whether to increase the write intensity.

The control section 4 controls the write intensity on the basis of the random pulse. In the third embodiment, the control section 4 does not change the write intensity in a case where the pulse of N = 0 is acquired and increases the write intensity in a case where the pulse of N = 1 is acquired.

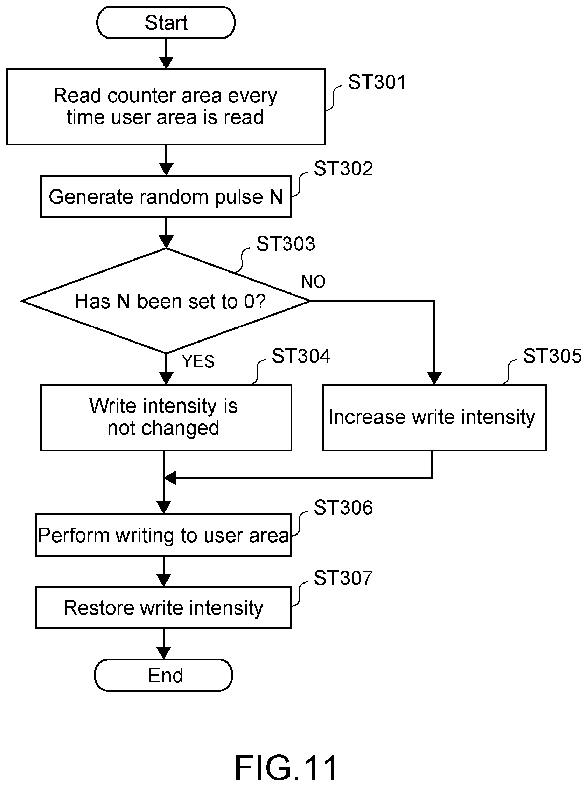

Fig. 11 is a flowchart illustrating a control method performed by the control section 4.

As illustrated in Fig. 11, in a case where a request for write access to the user area 10 is made (Step 301), access preprocessing at Step 302 to Step 305 is performed.

The random signal generating circuit 40 generates a random pulse N and outputs the random pulse N to the control section 4 (Step 302). The control section 4 determines whether N of the random pulse is 0 or 1 (Step 303).

In the third embodiment, in a case where N = 0 (YES at Step 303), the write intensity is not changed (Step 304). That is, the write intensity remains in the normal mode. In addition, in a case where N = 1 (NO at Step 303), the write intensity is increased (Step 305).

Writing to the user area 10 is performed after Step 304 or Step 305 (Step 306), and the control section 4 restores the write intensity (Step 307). That is, in the case of Step 304, writing to the user area 10 is performed in the normal mode, and the write intensity also remains in the normal mode at Step 307. In the case of Step 305, writing to the user area 10 is performed in the increased mode, and the write intensity is restored from the increased mode to the normal mode at Step 307.

As described above, it becomes possible with the semiconductor storage apparatus 300 according to the third embodiment to prevent damage to memory cells by lowering the possibility of continuous application of writing with a high write intensity compared to a case where the recovery phenomenon is induced by intensively performing rewriting in a state where the write intensity is increased.

### <Fourth Embodiment>

A semiconductor storage apparatus 400 according to a fourth embodiment of the present technology is explained.

The configuration of the semiconductor storage apparatus 400 according to the fourth embodiment is similar to that of the semiconductor storage apparatus 100 in the first embodiment.

In the fourth embodiment, the ferroelectric memory cells (user area 10) are set to a volatile mode in which the ferroelectric memory cells function as a volatile memory or a non-volatile mode in which the ferroelectric memory cells function as a non-volatile memory.

The volatile memory loses data (stored content) when external power supply is interrupted. That is, the ferroelectric memory cells are set to the volatile mode in a case where data retention is not necessary. In the fourth embodiment, the ferroelectric memory cells are set to the volatile mode such that the ferroelectric memory cells function as a volatile memory when recovery is performed at the time of next activation.

In addition, the non-volatile memory retain data even if external power supply is interrupted. That is, the ferroelectric memory cells are set to the non-volatile mode in a case where data retention is necessary. In addition, since the same data is retained continuously, imprint occurs, and 2Pr. decreases.

In addition, in the fourth embodiment, the flag area 2 is set to 0 in a case where the user area 10 in the non-volatile mode and is set to 1 in a case where the user area 10 is in the volatile mode.

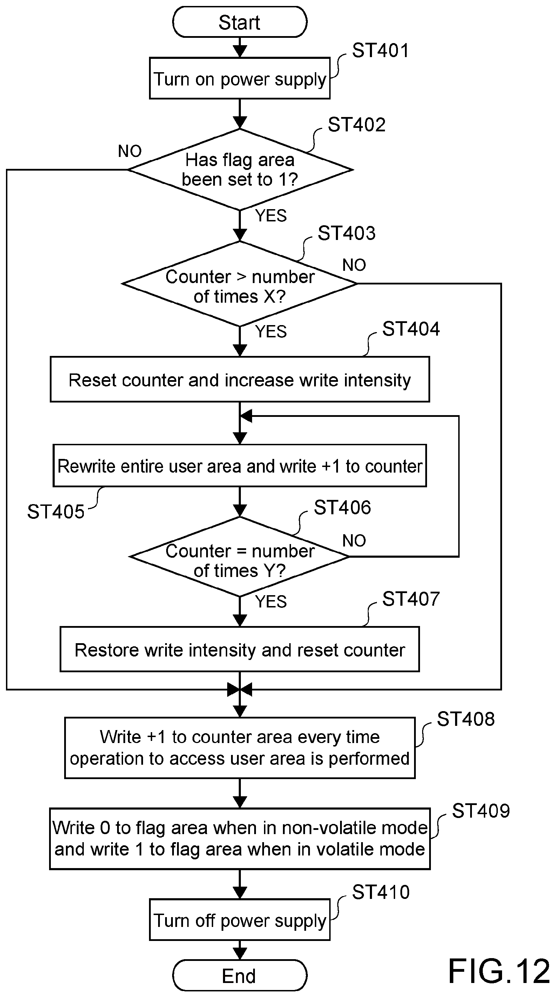

Fig. 12 is a flowchart illustrating a control method performed by the control section 4 according to the fourth embodiment.

As illustrated in Fig. 12, the power supply is turned on (Step 401), and the control section 4 makes a determination regarding the flag area 2 (Step 402).

In a case where the flag area 2 has been set to 1 (YES at Step 402), that is, in a case where the user area 10 is in the volatile mode, it is determined whether the number of times indicated by the counter stored in the counter area 3 has exceeded the predetermined number of times X (Step 403).

In a case where the number of times indicated by the counter has exceeded the predetermined number of times X (YES at Step 403), the semiconductor storage apparatus 400 transitions to a recovery operation. Accordingly, the counter is reset, and the write intensity is increased (Step 404). Note that, in this case, the write intensity may be increased by increasing the write voltage or by extending the write pulse width as described in the first embodiment and the second embodiment.

In the state where the write intensity is increased, a rewrite operation on the entire user area 10 is performed, and +1 is written to the counter (Step 405). The operation at Step 405 is repeated until the number of times indicated by the counter reaches a specified number of times Y (NO at Step 406). Note that the predetermined number of times X and the specified number of times Y may be the same numerical value or different values. Either number may be greater than the other.

In a case where rewriting is performed until the number of times indicated by the counter reaches the specified number of times Y (YES at Step 406), the write intensity is restored, and the counter is reset (Step 407).

After the counter is reset, +1 is written to the counter area 3, and the stored number of times indicated by the counter is incremented every time access to the user area 10 is made (Step 408).

In addition, in a case where the flag area 2 has been set to 0 (NO at Step 401) or in a case where the number of times indicated by the counter has not exceeded the predetermined number of times X (NO at Step 402), the process transitions to Step 408.

Before the power supply is turned off (Step 410), a command is given to make the user area 10 wait in either the volatile mode or the non-volatile mode (Step 409). For example, in a case where the memory area section 1 is set to the non-volatile mode for data retention, 0 is written to the flag area 2. In addition, in a case where data retention is not necessary, and the memory area section 1 is set to the volatile mode for performing a recovery operation at the time of next activation, 1 is written to the flag area 2.

Note that the command to make the user area 10 wait in either the volatile mode or the non-volatile mode may be given by a user. That is, the user can selectively use as appropriate the mode in which the memory device is desired to store data as a non-volatile memory device and the mode in which the memory device is intentionally not caused to store data as a non-volatile memory device. In addition, when either the volatile mode or the non-volatile mode is selected, the selection may be based on the number of times of access to the user area 10. For example, as a mode determination that is made at the time when the power supply is turned off, reading from the counter area 3 may be performed. The non-volatile mode (storage-enabled mode) may be selected if the number of times indicated by the counter is smaller than a preset number of times, and the volatile mode (storage-disabled mode) may be selected if the number of times indicated by the counter is greater than the preset number of times.

In addition, selection of the volatile mode or the non-volatile mode may not be performed during the use from Step 401 to Step 410, and the user may select (determine) a mode to use. For example, a mode may be selected depending on training or inference by an AI (Artificial Intelligence) neural network. For example, at the time of learning, data with different weights of synapses needs to be updated, and the memory to be used is required to retain data. Accordingly, the non-volatile mode is selected. In addition, at the time of inference, the memory is used only for calculation. Accordingly, the volatile mode is selected since data retention is not necessary. In this manner, depending on the state or setting of an application including the control section 4, instructions may be given in advance to cause the semiconductor storage apparatus 400 to switch between the volatile mode and the non-volatile mode.

As described above, unlike conventional semiconductor storage apparatuses, a fatigue monitor and an imprint monitor that use ferroelectric memory cells are not mounted on the semiconductor storage apparatus 400 according to the fourth embodiment. Accordingly, restrictions on the user area 10 are eliminated, and it becomes possible to increase the storage capacity. In addition, since recovery is implemented for the ferroelectric memory cell array all at once, variations in the degree of polarization amount recovery between the memory cells can be reduced. Thereby, the rewrite endurance can be enhanced, and deterioration of the data retention characteristics can be reduced.

### <Fifth Embodiment>

A semiconductor storage apparatus 500 according to a fifth embodiment of the present technology is explained.

The configuration of the semiconductor storage apparatus 500 according to the fifth embodiment is similar to that of the semiconductor storage apparatus 100 in the first embodiment.

In the fifth embodiment, the control section 4 controls the read intensity or the write intensity on the basis of a result of determination regarding the flag area 2. In addition, in the fifth embodiment, the control section 4 increases the read intensity by increasing the read voltage.

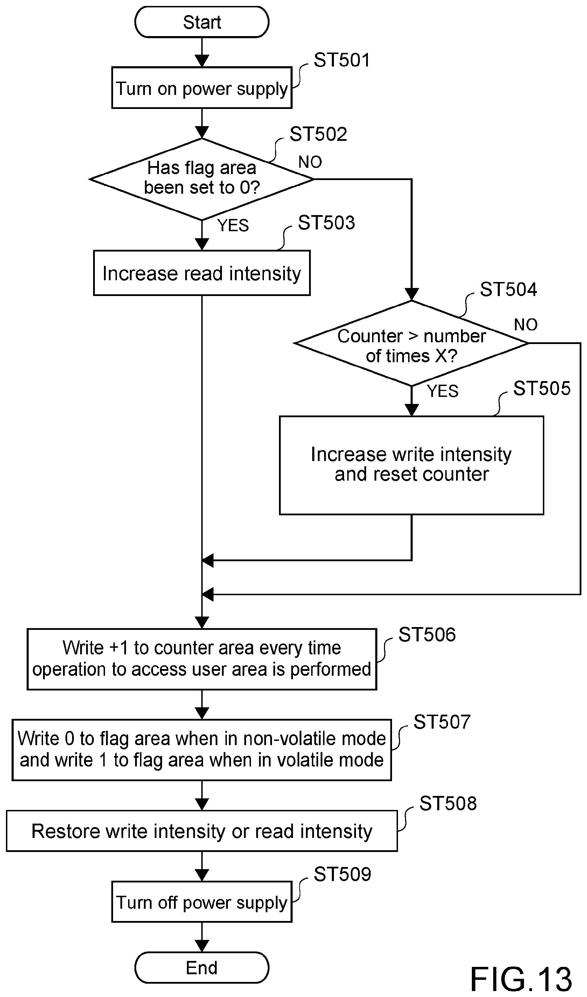

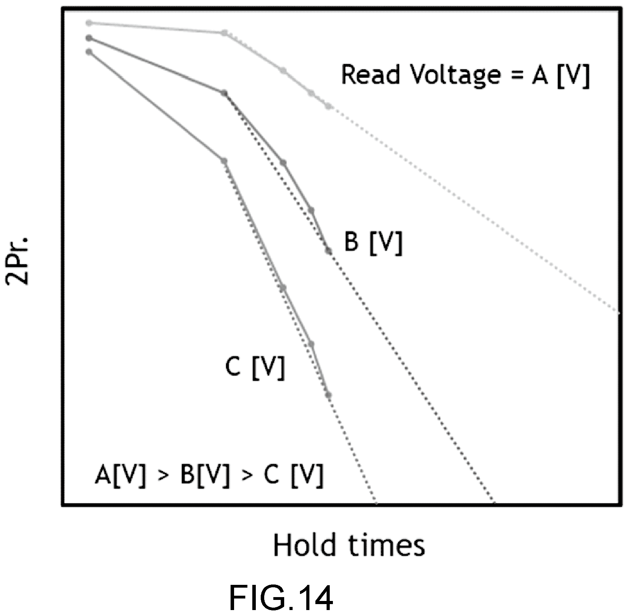

Fig. 13 is a flowchart illustrating a control method performed by the control section 4 according to the fifth embodiment. Fig. 14 illustrates simulation results in which read failures are mitigated by increasing the read voltage.

As illustrated in Fig. 13, the power supply is turned on (Step 501), and the control section 4 makes a determination regarding the flag area 2 (Step 502).

In a case where the flag area 2 has been set to 0 (YES at Step 502), that is, in a case where the flag area 2 is in the non-volatile mode, the read voltage is increased to increase the read intensity (Step 503). Thereby, read failures are mitigated.

In addition, in a case where the flag area 2 has been set to 1, that is, in a case where the flag area 2 is in the volatile mode, a determination as to whether the number of times indicated by the counter stored in the counter area 3 has exceeded the predetermined number of times X (Step 504).

In a case where the number of times indicated by the counter has exceeded the predetermined number of times X (YES at Step 504), the semiconductor storage apparatus 500 transitions to a recovery operation. Accordingly, the write intensity is increased, and the counter is reset (Step 505). Note that, in this case, the write intensity may be increased by increasing the write voltage or by extending the write pulse width as described in the first embodiment and the second embodiment.

Thereby, it becomes possible to achieve high reliability without giving unnecessarily significant application stress on the memory cells.

After the process of Step 503, Step 505, or NO at Step 504, every time access to the user area 10 is made, +1 is written to the counter area 3, and the stored number of times indicated by the counter is incremented (Step 506).

A command is given to make the user area 10 wait in either the volatile mode or the non-volatile mode (Step 507). For example, in a case where the memory area section 1 is set to the non-volatile mode for data retention, 0 is written to the flag area 2. In addition, in a case where data retention is not necessary, and the memory area section 1 is set to the volatile mode for performing a recovery operation at the time of next activation, 1 is written to the flag area 2.

After either the volatile mode or the non-volatile mode is selected, the write intensity or the read intensity is restored (Step 508), and the power supply is turned off (Step 509).

Note that, in the fifth embodiment, the control section 4 also functions as an intensity control section that controls the read intensity of reading to the user area.

As described above, in the semiconductor storage apparatus 500 according to the fifth embodiment, the write intensity is increased in the case of the volatile mode, and the read intensity is increased in the case of the non-volatile mode.

Conventionally, the write intensity is increased to aim to enhance reliability of ferroelectric memory cells. Typically, ferroelectric memories are expected to experience higher write access frequency than read access frequency, and there is a concern over the possibility of an increase in unnecessarily significant stress applied to the memory cells under conventional methods.

The present invention achieves enhancement and high reliability of the rewrite endurance by increasing the write intensity, and enables high reliability of the data retention characteristics by increasing only the read intensity. For example, Fig. 14 illustrates the remanent polarization amount (2Pr.) under respective write intensities with read voltages having the relationship A [V] > B [V] > C [V]. The vertical axis represents 2Pr. [µC/cm2], and the horizontal axis represents the hold time [s].

As illustrated in Fig. 14, it can be known that as the data retention time in the polarization state of ferroelectric elements increases, the degree of decrease in 2Pr. increases. However, it can be known that the degree of decrease in 2Pr. can be reduced by the rise of the read voltage (e.g. the read voltage A [V] and the read voltage C [V]). That is, unlike fatigue, imprint is mitigated simply by increasing the read intensity. It can be known that the fifth embodiment achieves certain results in actual devices.

### <Other Embodiments>

The present technology is not limited to embodiments explained above, and various other embodiments can be implemented.

In the embodiments described above, the flag area 2 is set to 0 or 1 on the basis of the two settings of the user area 10, which are the normal mode and the increased mode. This is not the sole example. The flag area 2 may be set to any number of bits, and the user area 10 may be set to a mode other than the two modes described above. For example, the user area 10 may be set to a first increased mode in which the voltage is increased at a first degree of increase compared to the normal mode, a second increased mode in which the voltage is increased at a second degree of increase compared to the normal mode, or a third increased mode in which the voltage is increased at a third degree of increase compared to the normal mode, and the flag area 2 may be set to a two-bit value like 00, 01, 10, or 11 corresponding to the normal mode or each increased mode.

Either one of the write intensity or the read intensity is increased in the embodiment described above. This is not the sole example. Both the write intensity and the read intensity may be set to the increased modes. In this case, the flag area may be set to a two-bit value (00, 01, 10, 11) since there are four patterns including patterns in which both intensities are increased or are not increased (the normal states are maintained) and patterns in which only either intensity is increased. Furthermore, the write intensity and the read intensity may be controlled on the basis of the number of times of access stored in the counter area 3. In a case where both the write intensity and the read intensity are increased in this manner, in addition to retention characteristics enhancement and endurance enhancement, signal level amplification until the completion of recovery of memory cells becomes possible. That is, although the signal level does not recover to the initial level after one or two recovery cycles when recovery is performed on the memory cells whose signal level has decreased due to fatigue, it becomes possible to reduce read failures during a recovery operation by increasing the read intensity (e.g. the read voltage) and increasing the signal level until recovery is completed.

Note that the present technology may also adopt the following configurations.
(1) A semiconductor storage apparatus including
   a control section that controls write intensity of writing to a user area included in a memory area, on the basis of a number of times of access to the user area.
(2) The semiconductor storage apparatus according to (1), further including
   a counter area that is provided independently of the memory area, the counter area storing therein the number of times of access, in which
   the control section controls the write intensity in a case where the number of times of access stored in the counter area has exceeded a predetermined number of times.
(3) The semiconductor storage apparatus according to (2), in which
   the control section increases the write intensity by increasing a write voltage.
(4) The semiconductor storage apparatus according to (3), in which
   the control section increases the write voltage stepwise.
(5) The semiconductor storage apparatus according to (3), in which
   the write intensity includes
      a normal mode in which the write voltage is in a normal state, and
      an increased mode in which the write voltage is in an increased state compared to the normal state, and
   the control section controls the write intensity to the increased mode in a case where the write intensity is in the normal mode, and controls the write intensity to the normal mode in a case where the write intensity is in the increased mode.
(6) The semiconductor storage apparatus according to (5), further including
   a flag area that is provided independently of the memory area, the flag area storing therein a setting of the user area, in which
   the setting of the user area includes the normal mode and the increased mode, and
   the control section controls the write intensity to the increased mode in a case where the setting of the user area stored in the flag area indicates the normal mode, and controls the write intensity to the normal mode in a case where the setting of the user area stored in the flag area indicates the increased mode.
(7) The semiconductor storage apparatus according to (2), in which
   the control section increases the write intensity by extending a write pulse width.
(8) The semiconductor storage apparatus according to (7), in which
   the control section extends the write pulse width stepwise.
(9) The semiconductor storage apparatus according to (7), in which
   the write intensity includes
      a normal mode in which the write pulse width is in a normal state, and
      an increased mode in which the write pulse width is in an extended state compared to the normal state, and
   the control section controls the write intensity to the increased mode in a case where the write intensity is in the normal mode, and controls the write intensity to the normal mode in a case where the write intensity is in the increased mode.
(10) The semiconductor storage apparatus according to (9), further including
   a flag area that is provided independently of the memory area, the flag area storing therein a setting of the user area, in which
   the setting of the user area includes the normal mode and the increased mode, and
   the control section controls the write intensity to the increased mode in a case where the setting of the user area stored in the flag area indicates the normal mode, and controls the write intensity to the normal mode in a case where the setting of the user area stored in the flag area indicates the increased mode.
(11) The semiconductor storage apparatus according to (1), further including
   a random number generating section that probabilistically outputs a random number indicating whether to increase the write intensity, in which
   the control section controls the write intensity on the basis of the random number.
(12) The semiconductor storage apparatus according to (1), further including
   a flag area that is provided independently of the memory area, the flag area storing therein a setting of the user area, in which
   the setting of the user area includes
      a volatile mode in which the user area functions as a volatile memory, and
      a non-volatile mode in which the user area functions as a non-volatile memory.
(13) The semiconductor storage apparatus according to (12), further including
   a counter area that is provided independently of the memory area, the counter area storing therein the number of times of access, in which
   the control section increases the write intensity in a case where the setting of the user area stored in the flag area indicates the volatile mode and in a case where the number of times of access stored in the counter area has exceeded a predetermined number of times.
(14) The semiconductor storage apparatus according to (13), in which
   in a case where the control section has increased the write intensity, the counter area resets the stored number of times of access, and stores therein a number of times of rewriting to the user area in a state where the write intensity has been increased, and
   the control section restores the write intensity in a case where the number of times of rewriting performed in the state where the write intensity has been increased has reached a specified number of times.
(15) The semiconductor storage apparatus according to (1), further including
   an intensity control section that controls a read intensity of reading to the user area.
(16) The semiconductor storage apparatus according to (15), further including
   a flag area that is provided independently of the memory area, the flag area storing therein a setting of the user area, in which
   the setting of the user area includes
      a volatile mode in which the user area functions as a volatile memory, and
      a non-volatile mode in which the user area functions as a non-volatile memory, and
   the intensity control section increases the read intensity in a case where the user area is in the non-volatile mode.
(17) The semiconductor storage apparatus according to (16), further including
   a counter area that is provided independently of the memory area, the counter area storing therein the number of times of access, in which
   the control section increases the write intensity in a case where the setting of the user area stored in the flag area indicates the volatile mode and in a case where the number of times of access stored in the counter area has exceeded a predetermined number of times.
(18) The semiconductor apparatus according to (16), in which
   the setting of the user area includes
   a first mode in which the read intensity and the write intensity are increased,
   a second mode in which either one of the read intensity or the write intensity is increased, and
   a third mode in which the read intensity and the write intensity are maintained in normal states.
(19) The semiconductor storage apparatus according to (1), in which
   the memory area is a ferroelectric memory cell.
(20) The semiconductor storage apparatus according to (19), in which
   the ferroelectric memory cell contains hafnium oxide and zirconium oxide.

### Reference Signs List

- 1: memory area section
- 2: flag area
- 3: counter area
- 4: control section
- 10: user area
- 20: voltage increasing circuit
- 40: random signal generating circuit
- 100, 200, 300, 400, 500: semiconductor storage apparatus

## Claims

1. A semiconductor storage apparatus comprising
a control section that controls write intensity of writing to a user area included in a memory area, on a basis of a number of times of access to the user area.

2. The semiconductor storage apparatus according to claim 1, further comprising
a counter area that is provided independently of the memory area, the counter area storing therein the number of times of access,
wherein
the control section controls the write intensity in a case where the number of times of access stored in the counter area has exceeded a predetermined number of times.

3. The semiconductor storage apparatus according to claim 2, wherein
the control section increases the write intensity by increasing a write voltage.

4. The semiconductor storage apparatus according to claim 3, wherein
the control section increases the write voltage stepwise.

5. The semiconductor storage apparatus according to claim 3, wherein
the write intensity includes
a normal mode in which the write voltage is in a normal state, and
an increased mode in which the write voltage is in an increased state compared to the normal state, and
the control section controls the write intensity to the increased mode in a case where the write intensity is in the normal mode, and controls the write intensity to the normal mode in a case where the write intensity is in the increased mode.

6. The semiconductor storage apparatus according to claim 5, further comprising
a flag area that is provided independently of the memory area, the flag area storing therein a setting of the user area, wherein
the setting of the user area includes the normal mode and the increased mode, and
the control section controls the write intensity to the increased mode in a case where the setting of the user area stored in the flag area indicates the normal mode, and controls the write intensity to the normal mode in a case where the setting of the user area stored in the flag area indicates the increased mode.

7. The semiconductor storage apparatus according to claim 2, wherein
the control section increases the write intensity by extending a write pulse width.

8. The semiconductor storage apparatus according to claim 7, wherein
the control section extends the write pulse width stepwise.

9. The semiconductor storage apparatus according to claim 7, wherein
the write intensity includes
a normal mode in which the write pulse width is in a normal state, and
an increased mode in which the write pulse width is in an extended state compared to the normal state, and
the control section controls the write intensity to the increased mode in a case where the write intensity is in the normal mode, and controls the write intensity to the normal mode in a case where the write intensity is in the increased mode.

10. The semiconductor storage apparatus according to claim 9, further comprising
a flag area that is provided independently of the memory area, the flag area storing therein a setting of the user area, wherein
the setting of the user area includes the normal mode and the increased mode, and
the control section controls the write intensity to the increased mode in a case where the setting of the user area stored in the flag area indicates the normal mode, and controls the write intensity to the normal mode in a case where the setting of the user area stored in the flag area indicates the increased mode.

11. The semiconductor storage apparatus according to claim 1, further comprising
a random number generating section that probabilistically outputs a random number indicating whether to increase the write intensity,
wherein
the control section controls the write intensity on a basis of the random number.

12. The semiconductor storage apparatus according to claim 1, further comprising
a flag area that is provided independently of the memory area, the flag area storing therein a setting of the user area, wherein
the setting of the user area includes
a volatile mode in which the user area functions as a volatile memory, and
a non-volatile mode in which the user area functions as a non-volatile memory.

13. The semiconductor storage apparatus according to claim 12, further comprising
a counter area that is provided independently of the memory area, the counter area storing therein the number of times of access,
wherein
the control section increases the write intensity in a case where the setting of the user area stored in the flag area indicates the volatile mode and in a case where the number of times of access stored in the counter area has exceeded a predetermined number of times.

14. The semiconductor storage apparatus according to claim 13, wherein
in a case where the control section has increased the write intensity, the counter area resets the stored number of times of access, and stores therein a number of times of rewriting to the user area in a state where the write intensity has been increased, and
the control section restores the write intensity in a case where the number of times of rewriting performed in the state where the write intensity has been increased has reached a specified number of times.

15. The semiconductor storage apparatus according to claim 1, further comprising
an intensity control section that controls a read intensity of reading to the user area.

16. The semiconductor storage apparatus according to claim 15, further comprising
a flag area that is provided independently of the memory area, the flag area storing therein a setting of the user area, wherein
the setting of the user area includes
a volatile mode in which the user area functions as a volatile memory, and
a non-volatile mode in which the user area functions as a non-volatile memory, and
the intensity control section increases the read intensity in a case where the user area is in the non-volatile mode.

17. The semiconductor storage apparatus according to claim 16, further comprising
a counter area that is provided independently of the memory area, the counter area storing therein the number of times of access,
wherein
the control section increases the write intensity in a case where the setting of the user area stored in the flag area indicates the volatile mode and in a case where the number of times of access stored in the counter area has exceeded a predetermined number of times.

18. The semiconductor storage apparatus according to claim 16, wherein
the setting of the user area includes
a first mode in which the read intensity and the write intensity are increased,
a second mode in which either one of the read intensity or the write intensity is increased, and
a third mode in which the read intensity and the write intensity are maintained in normal states.

19. The semiconductor storage apparatus according to claim 1, wherein
the memory area is a ferroelectric memory cell.

20. The semiconductor storage apparatus according to claim 19, wherein
the ferroelectric memory cell contains hafnium oxide and zirconium oxide.
